# EUROPEAN PATENT APPLICATION

(11) **EP 1 126 522 A1**
(43) Date of publication of application: **22.08.2001**
(21) Application number: 00400459.4
(22) Date of filing: 18.02.2000
(51) Int. Cl.: H01L 23/66, H01L 23/58, H01L 23/498

(54) **Packaged integrated circuit with radio frequency antenna**

(71) Applicant: ALCATEL, 75008 Paris (FR)
(72) Inventor: Op 't Eynde, Frank Nico Lieven, 3012 Wilsele (Leuven) (BE); Dehaeck Willy G.J.Y., 9700 Oudenaarde (BE); Wuyts, Ilse, 9850 Nevele (BE); Terryn, Steven G.A., 8930 Lauwe (BE); Olyslager, Frank, 5551 VM Valkenswaard (NL); Rogier, Hendrik, 9500 Geeraardsbergen (BE); De Zutter, Daniel, 9900Eeklo (BE); Van Vliet, Rick, Dormansland Surrey, RH7 6QU (GB)
(74) Representative: Narmon, Gisèle

(57) **Abstract**

A Packaged Integrated Circuit, for use in a radio frequency apparatus, the Packaged Integrated Circuit comprises one or more radio frequency components that are included in an Integrated Circuit die. The Integrated Circuit die is associated with a radio frequency antenna. The radio frequency antenna is also included in the Packaged Integrated Circuit but is excluded from the Integrated Circuit die.

## Description

The present invention relates to a Packaged Integrated Circuit as described in the preamble of claim 1.

Such a Packaged Integrated Circuit is already known in the art, e.g. from the ATMEL announcement "*ATMEL announces Bluetooth solution*" at November 8, 1999 together with the ATMEL Bluetooth solution backgrounder *"No more cables The Bluetooth wireless standard and ATMEL Corporation's instant time-to-market Bluetooth solution" Both documents are published at the ATMEL website.* Therein, a Bluetooth transceiver is described consisting of a multi-chip module that includes the radio, baseband and flash memory in a ball grid array package. This module is assembled on a Printed Circuit Board, together with diverse external discrete components, such as a filter and an antenna. Because of the use of such a transceiver in different kind of small portable devices such a transceiver device should necessarily be very small. Further taking in account the expectedly large number of such transceivers applied in Bluetooth supporting devices, the production cost and mounting cost of such a transceiver should be low.

An object of the present invention is to provide a Packaged Integrated Circuit of the above known type but which is smaller and has a reduced cost with respect to the known ones.

According to the invention, this object is achieved by the Packaged Integrated Circuit described in claim 1.

Indeed, this object is achieved by providing at least one radio frequency component in an Integrated Circuit die implemented in an Packaged Integrated Circuit while the radio frequency antenna is also integrated in the same Package. An entire package in one part, including an antenna, can be integrated in a radio application such as a Bluetooth application instead of combining a radio frequency module and a separate antenna on a Printed Circuit Board for application in such a radio application such as Bluetooth. In this way space on the Printed Circuit Board and in the radio application housing is saved and at the same time cost for implementation of the radio application is reduced because only one action is needed instead of one for mounting the radio module and one for mounting the antenna on the Printed Circuit Board and subsequently handling the interconnection of both elements.

Another characterising embodiment of the present invention is described in claim 2.

The radio frequency antenna is constituted of al least one metal object inside an Integrated Circuit Package which houses the elements of the Packaged Integrated Circuit. By using an existing or additional metal object within the Integrated Circuit package the antenna is built up within the package of the Integrated Circuit.

Subsequently characterising embodiments of the present invention are described in claim 3 and claim 4 respectively.

In both alternative embodiments a metal object within the package is used for implementing the radio frequency antenna. At first, in claim 3, the Integrated radio frequency antenna is constituted by a wire bonding coupling for example an output of the Integrated Circuit die to an output terminal. This is feasible if the length of a wire bonding is ½λ or ¼λ of the targeted, to be received or transmitted radio signal wavelength. Secondly, in claim 4, as an alternative, a metal lead-frame inside the Integrated Circuit package is used as a radio frequency antenna.

A further characterising embodiment of the present invention is described in claim 5.

As another alternative radio frequency antenna, at least one planar metal pattern can be used as an antenna. Such a, at least one metal pattern may be included in the Integrated Circuit package by means of moulding it in the package material or by realising the patterns on the surface of the package. Additionally the antenna consists of a grounded metal plane. The pattern and the grounded plane are separated by an insulating layer within the Integrated Circuit package.

Yet another characterising embodiment of the present invention is described in claim 6.

The radio frequency antenna consists of a planar slot-pattern placed on a grounded substrate. This substrate is realised on the surface of an Integrated Circuit package. By using a ceramic material having a high dielectric constant the radio frequency antenna dimensions on the ceramic substrate can be minimised even more.

Also another characterising embodiment of the present invention is described in claim 7.

The slot pattern of the radio frequency antenna on the grounded substrate consists of a first S-shaped slot whereof the length of this first S-shaped slot determines the resonance frequency of the radio frequency signal to be received or transmitted. The S-shape of the carve results in a non-linearly polarised radiation pattern. By applying this technique of shaping the antenna it is facilitated to adapt the radio frequency antenna for another resonance frequency, just by making a slight modification to the shape or the dimensions of the antenna. In this way the antenna is frequency tuneable.

A subsequent characterising embodiment of the present invention is described in claim 8.

There is additional to the first S-shaped slot a second S-shaped slot that is rotated 90 degrees with regard to the first S-shaped slot. This second S-shaped slot suppresses higher order resonance at harmonic frequencies of the operation frequency of the radio frequency signal and consequently reduces the bandwidth of the radio frequency signal. The S-shape of the carve results in a non-linearly polarised radiation pattern, and the combination of both S-shaped slots defines not only the resonance frequency and bandwidth but also constitutes some filter characteristics by suppressing all other harmonic frequencies except the needed radio frequency signal. By applying this technique of shaping the antenna it is facilitated to adapt the radio frequency antenna to another resonance frequency and also to suppress other harmonic frequencies, just by making a slight modification to the shape or the dimensions of the antenna. In this way the antenna is also bandwidth tuneable. By applying the second S-shape the antenna itself provides a filter characteristic, hereby reducing the need of applying an additional filtering element.

Further characterising embodiments of the present invention are mentioned in the appended claims 9, 10 and 11.

By integrating such a radio frequency module in a standard Integrated Circuit package such as a Ball grid array package, a Quad Flat Pack package or a Small Outline package or any other standard package, the packages can be treated by standard equipment such as a solder-flow machine or testing equipment resulting in a reduction of cost. By using these standard packages also the size and the cost of the overall radio equipment is reduced.

In addition the present invention also relates to a radio frequency module including at least one packaged Integrated Circuit as described above.

The above and other objects and features of the invention will become more apparent and the invention itself will be best understood by referring to the following description of an embodiment taken in conjunction with the accompanying drawings wherein:

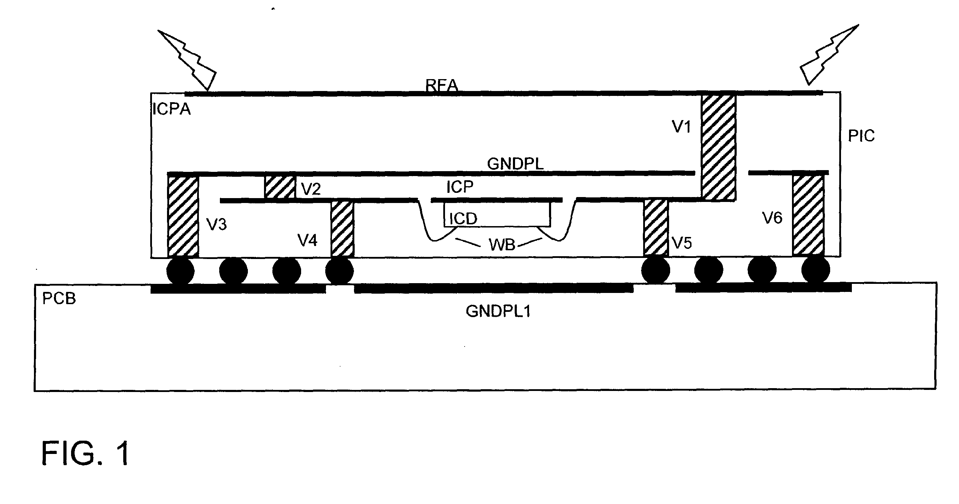

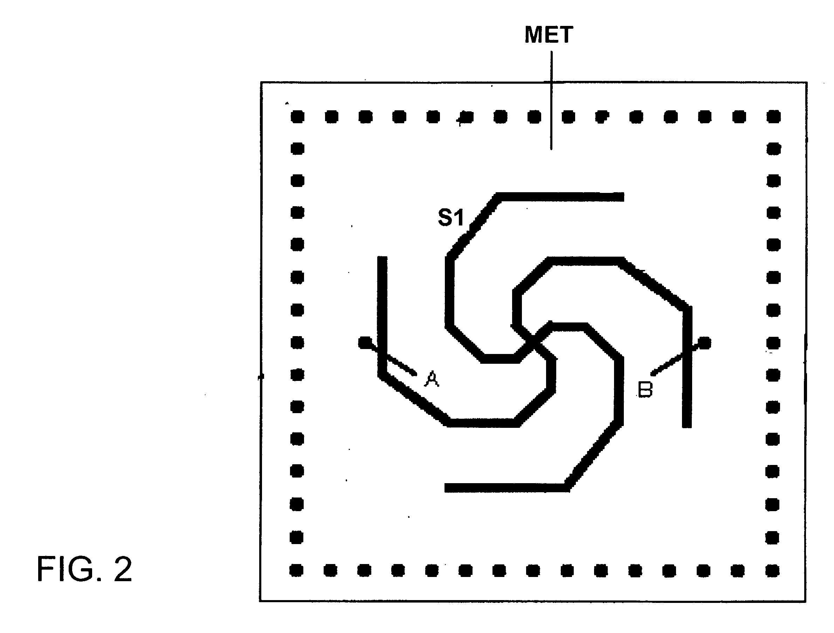

FIG. 1 represents a ball grid array package wherein a radio frequency module together with a radio frequency antenna is implemented; FIG 2 represents the pattern of the slot antenna used in the radio frequency module of the FIG. 1.

In the following paragraphs, referring to the drawings, an implementation of the method according to the present invention will be described. In the first part of this description the main elements of the Ball Grid Array package ICPA, as presented in FIG. 1, wherein the Packaged Integrated Circuit of the present invention is implemented, is described. This part is succeeded by a description of all interconnections between each of the before mentioned elements. Subsequently the actual execution of the implementation of the present invention is described.

The Ball Grid Array (BGA) package ICPA of the present invention is a cavity-down package that can be mounted on a Printed Circuit Board PCB. This BGA package basically consists of planar metal layers GNDPL, ICP, separated by insulating layers. The insulating layers are realised in a ceramic material. At the top of the Ball Grid Array package ICPA, a first metalisation layer MET is realised. The antenna RFA is etched, using the well-known slot technology, in the metalisation layer MET. Below the radio frequency antenna there is a ceramic insulating layer and the planar metal layer GNDPL, serving as ground plane. Further below the ground plane GNDPL there is another insulating layer and the metal layer ICP, serving as an interconnection plane. On this layer ICP, interconnections between all pins of an Integrated Circuit die ICD and all output connectors or internal elements are etched. The output terminals of the BGA package are solder balls that can be soldered on a Printed Circuit Board PCB.

The Integrated Circuit die ICD contains electronic radio frequency components such as transistors, capacitors, inductors, and resistors.

The vertical interconnections between all elements are performed using via holes which are holes in the insulating layers, filled with metal. The connections towards the Printed Circuit Board PCB are realised with solder balls.

The terminals of the radio frequency antenna RFA are coupled to the Integrated Circuit die ICD by via-holes such as V1, and by metal interconnections on layer ICP. The ground plane GNDPL is connected to an electrical ground using via holes V3 and V6 coupled to a ground plane GNDPL1 on the Printed Circuit Board PCB. The Integrated Circuit die ICD is also coupled to ground plane GNDPL by via V2. Via's V4 and V5 are used to couple the Integrated Circuit die signal outputs to other subsequent elements mounted on the Printed Circuit Board PCB. The pins of the Integrated Circuit die ICD are coupled to the interconnection plane ICP via wire bonds WB.

In FIG. 2, more details are shown of the radio frequency antenna RFA, as built in the first metallisation layer on top of the BGA-package. The antenna RFA is etched by using the well-known slot technology, where a "slot" means an opening in a metal pattern. The antenna RFA consists of a first S-shaped slot S1 and a second S-shaped slot rotated 90 degrees with regard to the first S-shaped slot S2. The antenna is surrounded by a square array of via holes VH at the edge of the antenna.

In the following paragraph the relevance and positioning of the previously mentioned elements is explained.

First, by using the cavity down package, it is facilitated to shield the Integrated Circuit die ICD from radiation by placing the die in between two ground planes GNDPL and GNDPL1. On the other hand the radio frequency antenna RFA is also shielded from the Integrated Circuit die ICD by the application of ground plane GNDPL. This structure enables to combine an Integrated Circuit die ICD and an antenna RFA within one package without mutual influence and/or performance disturbance.

The antenna RFA consists of a slot pattern that is placed on a ceramic insulation layer. Because of the high dielectrical constant εr of the Ceramic material and the ability to accurately control the dimensions such as the thickness of the layers and the pattern layout, the antenna dimensions can be minimised and the antenna dimensions can be accurately reproduced. The slot pattern itself consists of two S-shaped slots S1, S2 rotated by 90 degrees. The length of the first S-shaped slot S1 determines the antenna resonance frequency. The second S-shaped slot S2 suppresses higher order resonances at harmonic frequencies of the operation frequency and reduces the bandwidth. The S-shape of the carve results in a non-linearly polarised radiation pattern, and the combination of both S-shaped slots defines not only the resonance frequency and bandwidth but also defines some filter characteristics by suppressing all other harmonic frequencies except the needed radio frequency signal.

The S-shape of the carve results in a non-linearly polarised radiation pattern. By applying this technique of shaping the antenna it is facilitated to adapt the radio frequency antenna RFA for another resonance frequency, just by making a slight modification to the shape or dimensions of the antenna. In this way the antenna is frequency tuneable.

Further, by applying this technique of shaping the antenna it is facilitated to adapt the radio frequency antenna RFA for another resonance frequency but also for suppressing other harmonic frequencies, just by making a slight modification to the shape or the dimensions of the antenna. In this way the antenna is also bandwidth tuneable. By applying the second S-shape the antenna itself provides with filter characteristics disposing of the need of applying an additional filtering element.

The antenna is surrounded by a square array of via-holes that ground the metallisation at the edges of the antenna in order to avoid fringing effects.

The antenna is excited differentially in the points A and B of FIG. 2, the connection to the die is made with via-holes on these two points. Further, the impedance seen from point A and point B is exactly the same due to the symmetry of the antenna.

The technique used for minimising the size of the antenna, the antenna-filter and the shielding between the silicon and the antenna, makes it possible to integrate all radio functions into one very small chip package solution for the Bluetooth application.

It is to be mentioned that embodiments using metal objects in the Integrated Circuit package such as a wire bond and a metal lead-frame are also suitable for implementing a radio frequency antenna within the Packaged Integrated Circuit.

It is further to be mentioned that instead of using a BGA-package also a Small Outline package, a Quad Flat Pack Package or any other standard package could be used to provide the same advantages as a BGA-package does. The invention can also be applied to packages, containing insulation layers realised in materials other than ceramic materials.

While the principles of the invention have been described above in connection with specific apparatus, it is to be clearly understood that this description is made only by way of example and not as a limitation on the scope of the invention, as defined in the appended claims.

## Claims

1. Packaged Integrated Circuit (PIC), comprising at least one radio frequency component included in an Integrated Circuit die (ICD) being associated with a radio frequency antenna (RFA), said Integrated Circuit die (ICD) being included in said Packaged Integrated Circuit (PIC) **CHARACTERISED IN THAT** said radio frequency antenna is also included in said Packaged Integrated Circuit package (PIC) and is excluded from said Integrated Circuit die (ICD).

2. Packaged Integrated Circuit (PIC) according to claim 1,
**CHARACTERISED IN THAT** said Packaged Integrated Circuit (PIC) includes an Integrated Circuit Package (ICPA) which houses said at least one radio frequency component and said radio frequency antenna (RFA) which is constituted by at least one metal object that is part of said Integrated Circuit package.

3. Packaged Integrated Circuit (PIC) according to claim 2,
**CHARACTERISED IN THAT** said radio frequency antenna (RFA) is constituted by a wire bonding coupled to said Integrated Circuit die (ICD).

4. Packaged Integrated Circuit (PIC) according to claim 2,
**CHARACTERISED IN THAT** said radio frequency antenna (RFA) is applied on a metal lead frame of said Integrated Circuit package (ICPA).

5. Packaged Integrated Circuit (PIC) according to claim 1,
**CHARACTERISED IN THAT** said radio frequency antenna (RFA) consists of at least one planar metal pattern separated from a grounded metal plane by an insulating layer.

6. Packaged Integrated Circuit (PIC) according to claim 5,
**CHARACTERISED IN THAT** said planar metal pattern is a metal slot-pattern and said insulating layer is ceramic layer.

7. Packaged Integrated Circuit (PIC) according to claim 6,
**CHARACTERISED IN THAT** said slot pattern consists of a first S-shaped slot.

8. Packaged Integrated Circuit (PIC) according to claim 7,
**CHARACTERISED IN THAT** said radio frequency antenna (RFA) comprises a second S-shaped slot rotated 90 degrees with regard to said first S-shaped slot.

9. Packaged Integrated Circuit (PIC) according to claim 1,
**CHARACTERISED IN THAT** said Integrated Circuit package (ICPA) is a Ball Grid Array package.

10. Packaged Integrated Circuit (PIC) according to claim 1,
**CHARACTERISED IN THAT** said Integrated Circuit package (ICPA) is a Quad Flat Pack package.

11. Packaged Integrated Circuit (PIC) according to claim 1,
**CHARACTERISED IN THAT** said Integrated Circuit package is a Small Outline package.

12. Radio Frequency Module including at least one Packaged Integrated Circuit (PIC) according to any of the claims 1 to 11.
